Europäisches Patentamt

European Patent Office

Office européen des brevets

(19)

(11) Publication number: **0 317 993**

**A1**

(12) **EUROPEAN PATENT APPLICATION**

(21) Application number: 88119563.0

(22) Date of filing: 23.12.80

(51) Int. Cl.⁴: **H01L 29/80 , H01L 29/205 , H01L 29/267**

(30) Priority: 28.12.79 JP 171026/79
28.12.79 JP 171027/79
17.06.80 JP 82035/80
27.06.80 JP 87527/80

(43) Date of publication of application:
**31.05.89 Bulletin 89/22**

(60) Publication number of the earlier application in
accordance with Art.76 EPC: **0 033 037**

(84) Designated Contracting States:
**DE FR GB NL**

(71) Applicant: **FUJITSU LIMITED**
**1015, Kamikodanaka Nakahara-ku**
**Kawasaki-shi Kanagawa 211(JP)**

(72) Inventor: **Mimura, Takashi c/o Fujitsu Limited**
**Patent Depatment 1015 Kamikodanaka**
**Nakahara-ku**
**Kawasaki-shi Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

(54) **Heterojunction semiconductor devices.**

(57) An active semiconductor device, comprising
a source layer (1, 21, 41, 61) of a semiconductor doped with donor impurity,
a channel layer (2, 22, 42, 62) of a semiconductor having a larger electron affinity than the semiconductor of the source layer and forming a heterojunction with the source layer, wherein a channel is formed in the channel layer along the heterojunction,
at least one control terminal (10, 30, 50, 70), having a Schottky gate configuration, formed on the source layer over a portion of said heterojunction, and
first (31, 32; 51,52; 71,72) and second (32, 31; 52,51; 72,71) output terminals;
said source layer having a sufficiently small thickness, at least under the said one control terminal, so as to be entirely depleted of majority carriers under the said one control terminal,
wherein said first and second output terminals are electrically connected, at least under said one control terminal, by an accumulation of electrons with high mobility in said channel in said channel layer depending on a control voltage applied to said control terminal.

Fig. 11

## Heterojunction Semiconductor devices

This invention relates to semiconductor devices, and particularly but not exclusively to FETs.

Field effect transistors available in the prior art may be classified into three types, including junction gate type, insulated gate type and Schottky barrier type. Out of these three families, the insulated gate type and the Schottky barrier type (Metal semiconductor or MES) are fairly easy to produce in the form of integrated circuits. Therefore, insofar as the integrated circuits are concerned, these two types are predominantly employed. For the purpose of improving the switching speed of the FETs, various means, including decrease of geometrical dimensions, are employed. However, improvement in switching speed is inherently limited by electron mobility or the speed of electrons moving in a conductive channel. In other words, improvement in electron mobility is the easiest means or even essential means for improvement of the switching speed of an FET. It was believed, however, that electron mobility is determined by the kind and concentration of impurity doped into a semiconductor, temperature, et al, and that there is a limitation for improvement of electron mobility.

It is noted, however, that R. Dingle et al. disclosed results of their efforts for improvement of electron mobility, which were successfully realized by a multilayered structure of semiconductors including plural heterojunctions. Their report entitled "Electron Mobilities in Modulation-doped Semiconductor Heterojunction Superlattices" disclosed in Applied Physics Letters, Vol33, Pages 665 through 667 on October 1, 1978 reveals that although the electron mobility of GaAs doped n-type to $10^{17}/cm^3$ is approximately 5,000 $cm^2$·V.sec at the temperature of $300°$ K, a multilayered structure fabricated by alternately growing n-doped AlGaAs layers and undoped or unintentionally doped GaAS layers allows the GaAs layers an electron mobility of approximately 20,000 $cm^2$/V. sec at the temperature of $77°$ K. This improvement in electron mobility was realised in the electrons accumulated in the GaAs layer contiguous with the heterojunction due to the difference in electron affinity, because of the lower magnitude of ionized-impurity scattering in the undoped or unintentionally doped GaAs layer at a cryogenic temperature.

Attention is directed to EP-A-0 017 531 and EP-A-0 025 742, which form part of the state of the art by virtue of Article 54(3) EPC, and to EP-A-0 005 059.

An object of this invention is to provide active semiconductor devices with high electron mobility.

More generally, according to the present invention, there is provided an active semiconductor device, comprising:

a source layer of a semiconductor doped with donor impurity,

a channel layer of a semiconductor having a larger electron affinity than the semiconductor of the source layer and forming a heterojunction with the source layer, wherein a channel is formed in the channel layer along the heterojunction,

at least one control terminal, having a Schottky gate configuration, formed on the source layer over a portion of said heterojunction, and

first and second output terminals,

said source layer having a sufficiently small thickness, at least under the said one control terminal, so as to be entirely depleted of majority carriers under the said one control terminal,

wherein said first and second output terminals are electrically connected, at least under said one control terminal, by an accumulation of electrons with high mobility in said channel in said channel layer depending on a control voltage applied to said control terminal.

In preferred embodiments of the invention, an active semiconductor device with high electron mobility is provided with a single active heterojunction formed between a pair of layers fabricated with two different semiconductors. The two different semiconductors are preferably selected to be allowed a substantial difference in the amount of electron affinity between each other, for example a pair of GaAs and AlGaAs. Further the semiconductor layer having the lower amount of electron affinity is preferably doped with an n-type impurity. Due to the difference in electron affinity, some quantity of electrons contained in the semiconductor layer having a lower amount of electron affinity are depleted from the same semiconductor layer and move to a semiconductor layer having a higher amount of electron affinity. The electrons accumulate in an extremely thin region close to the single heterojunction. These accumulated electrons provide a channel. From this viewpoint, the semiconductor layer having a lower amount of electron affinity, and the semiconductor layer having a higher amount of electron affinity, will be referred to respectively as an electron source region and a channel region. The electrons accumulated along the single heterojunction do not spread beyond the spread of electron wave. In other words, the entire quantity of the electrons are confined in an extremely thin region with a thickness of several tens of Angstroms and spatially separated from the doped n-type impurity atoms. This means the electrons suffer from a lower magnitude of ionized-impurity scattering. Therefore, the mobility of the electrons is extremely improved particularly at the cryogenic temperature at which the effect of ionized-impurity scattering becomes dominant in determining the electron mobility. On the other hand, the electron source region is depleted to some extent. Therefore, when the thickness of the electron source region is selected to a proper magnitude, it is possible to make the electron source region entirely depleted. As a result, the electrons accumulated along the single hetero junction are allowed to function as the channel for the layer configuration consisting of an electron source region and a channel region. Accordingly, when one or more Schottky barrier gates together with a source and a drain are placed on the top surface of the layer configuration, an FET whose path of electric current is limited to the channel formed of the electrons accumulated along the single heterojunction can be fabricated.

As described earlier, it is desirable for an electron source region to be doped with n-type impurity atoms. However, a channel region can be either undoped or unintentionally doped or n-doped or even p-doped, unless the positive dopant concentration is extremely high.

It is noted that the thickness of an electron source region is required to be less than a specific thickness which is determined predominantly by the kind of semiconductors employed and the temperature at which the device is employed.

The above described novel concept of active semiconductor devices with high electron mobility may be embodied in various manners.

In the layer configuration of an embodiment of the invention a channel region is grown on a substrate before growing an electron source region on the channel region and placing one or more gates, a source and a drain on the layer configuration.

The embodiment functions as either a normally-on mode (depletion mode) or a normally-off mode (enhancement mode) depending on whether the thickness of an electron source region is larger than a specific thickness which is determined predominantly by the kind of semiconductors employed and the temperature at which the device is employed.

In addition to the pair of GaAs and AlGaAs, the pairs of Ge and AlGaAs, Ge and GaAs, InSb and CdTe, InAs and GaSb, et al. can be utilized.

The substance can be fabricated with either a semiconductor or an insulator. In either case, a single heterojunction constituting a single channel connecting a source and a drain is desirable.

For a better understanding of the invention, and to show how the same may be carried into effect, reference will be made by way of example only to the accompanying diagrammatic drawings, in which:

Figure 1 is a cross-sectional view of an FET having a multilayered superlattice structure fabricated with n-doped $Al_{0.3}Ga_{0.7}As$ layers and undoped GaAs layers interleaving a plurality of heterojunctions and which was produced for trial without success;

Figure 2 is a graph showing the source-drain voltage vs. source-drain current characteristic with gate-source voltage as a parameter, of the FET whose layer configuration is shown in Figure 1;

Figure 3 is a graph showing electron concentration vs. depth from the surface of the layer configuration shown in Figure 1;

Figure 4 is an energy band diagram of a layer configuration constituted with a metal layer, an $Al_{0.3}Ga_{0.7}As$ layer and an undoped GaAs layer interleaving a single heterojunction between them, drawn under a condition of thermal equilibrium;

Figure 5 is an energy band diagram of a layer configuration which depicts a boundary of the thickness of an n-doped AlGaAs layer which allows regulation of conductivity with a field effect caused by a metal layer, drawn under a condition of thermal equilibrium;

Figure 6 is an energy band diagram corresponding to the diagram shown in Figure 5, drawn under field effect;

Figure 7(a) is an energy band diagram corresponding to Figure 5, showing the case in which the barrier gap between a metal layer and an n-doped AlGaAs layer is larger that the barrier gap between the AlGaAs layer and a GaAs layer, under a condition of thermal equilibrium ;

Figure 7(b) is an energy band diagram corresponding to Figure 5, showing the case in which the barrier gap between an n-doped AlGaAs layer and a GaAs layer is larger than the barrier gap between the AlGaAs layer and a metal layer, under a condition of thermal equilibrium;

Figure 8 is an energy band diagram corresponding to Figure 7(a), showing the case in which the thickness of an n-doped AlGaAs layer is thinned , under a condition of thermal equilibrium;

Figure 9 is an energy band diagram showing the same layer configuration as for Figure 8, showing the position under a field effect;

Figure 10 is an energy band diagram equivalent to Figure 4, drawn for the purpose of defining various variables;

Figure 11 is a cross- sectional view of an FET operable in the normally-on mode, in accordance with an embodiment of the invention;

Figure 12 is a cross-sectional view of an FET operable in the normally-off mode, in accordance with another embodiment of the invention; and

Figure 13 is a cross-sectional view of a charge coupled device in accordance with the invention.

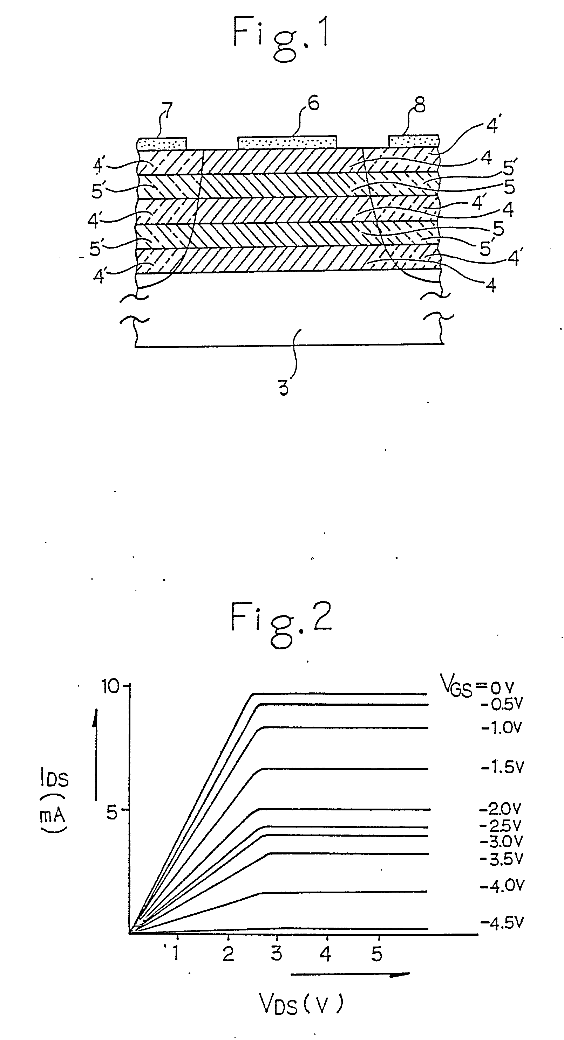

There was envisaged a concept that the above mentioned phenomenon reported by R. Dingle et al. could be utilised for improvement of electron mobility and for development of an FET with an extremely high switching speed. For reduction of the concept to practice, there was produced for trial an FET comprising a multilayered superlattice structure fabricated with n-doped $Al_{3.0}Ga_{0.7}As$-s and undoped GaAs-s, as shown in Figure 1. Referring to the same figure, plural n-doped AlGaAs layers (4) and plural undoped GaAs layers (5) are grown one after the other to form a multilayer on a GaAs substrate (3) which is a semi-insulator. Reference numerals (4') and (5') respectively show n-doped AlGaAs layers and n-doped GaAs layers for forming source and drain regions. On top of these n-doped layers, a source electrode (7) and a drain electrode (8) are placed. A Schottky gate (6) is provided between the source (7) and the drain (8).

The relations between the source-drain voltage and the source-drain current were measured for the above described FET, varying the gate-source voltage as a parameter. Figure 2 shows a result of the measurement. In the same figure, X-axis and Y-axis respectively depict the source-drain voltage $V_{DS}$ and the source-drain current $I_{DS}$. The gate-source voltage $V_{GS}$ is shown for each curve as a parameter.

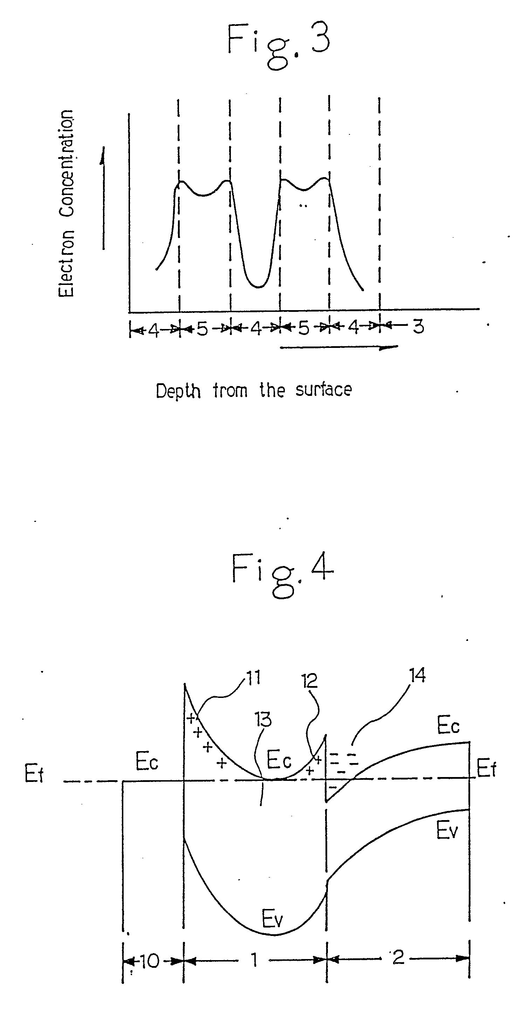

Figure 2 shows that the transfer conductance $G_m$ of this FET is non-linear for the gate-source voltage $V_{GS}$. For example, the transfer conductance $G_m$ is extremely small for the gate-source voltage range of $-0.2V \leq V_{GS} \leq -3.0V$. Further, the amplification characteristic is also non-linear. Therefore, it is clear that this FET can not be applicable for practical use. In order to determine the causes of such a characteristic, the relations between the electron concentration and the depth from the top surface were measured. Figure 3 shows a result of the measurement. The figure shows a large magnitude of the electron concentration for the undoped GaAs layers (5) which have a large amount of electron affinity and a small magnitude of the electron concentration for the n-type AlGaAs layers (4) which have a small amount of electron affinity. Based on a fact that an increasingly larger amount of the gate-source voltage $V_{GS}$ causes the electrons located at an increasingly deeper region to be involved with conduction, it was determined that the non-linear distribution of electron concentration shown in Figure 3 is the cause for the non-linear characteristic between the transfer conductance $G_m$ and the gate-source voltage $V_{GS}$ shown in Figure 2.

Based on the above described experimental results, it was determined that a multilayered structure of semiconductors including plural heterojunctions as shown in Figure 2 is not appropriate for production of a semi-conductor device.

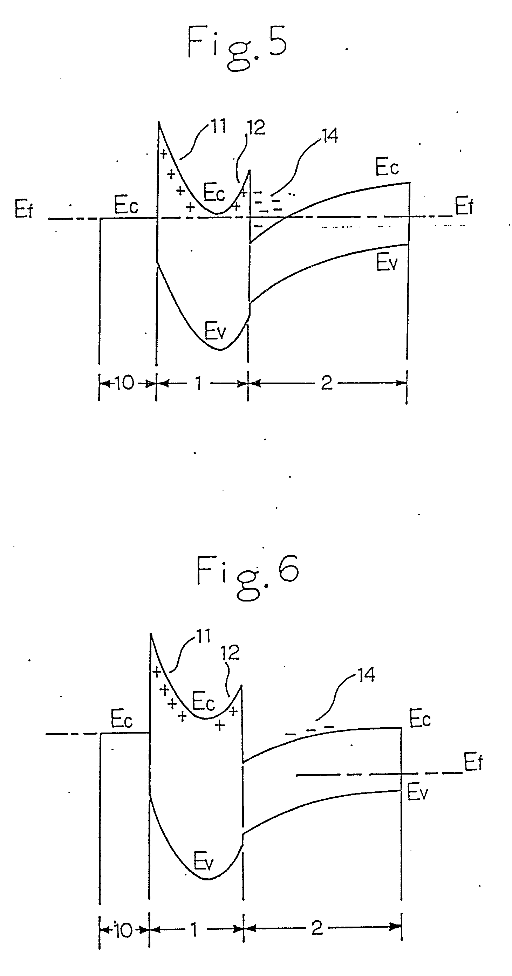

Thereafter, there was studied a case in which a single heterojunction is formed between two kinds of semiconductors having different amounts of electron affinity from each other. With reference to the drawings, results of the study will be described below. Figure 4 shows the energy band diagram of a layer configuration interleaved by a single heterojunction formed between an n-type $Al_{0.3}Ga_{0.7}As$ layer and an undoped GaAs layer, drawn under thermal equilibrium conditions. Referring to the same figure, a metal layer (10) makes a Schottky contact with an n-type AlGaAs layer (1). A GaAs layer (2) forms a single heterojunction with the n-type AlGaAs layer (1). From the functional viewpoint, the GaAs layer (2) is allowed to be either undoped or n-doped to a certain extent or even p-doped to a rather less extent. References $E_c$, $E_v$ and $E_f$ respectively show the energies of a valence band, a conduction band and the Fermi level. Due to the Schottky effect, some quantity of electrons contained in the n-type AlGaAs layer (1) move into the interface between the metal layer (10) and the AlGaAs layer, leaving a depletion layer (11) in the n-type AlGaAs layer. As a result, the energy band diagram is reformed as depicted in the same figure. In addition, due to the difference in electron affinity, some quantity of electrons contained in the n-type AlGaAs layer (1) move into the GaAs layer (2) across the heterojunction formed between them. As a result, the energy band diagram is reformed as depicted in the same figure. It is noted that if the thickness of the n-type AlGaAs layer (1) exceeds a certain amount, an n-type layer (13) remains between the depletion layers (11) and (12). The electrons depleted from the n-type AlGaAs layer (1) accumulate along the heterojunction, forming an electron accumulation (14) in the GaAs layer (2). As a result, the energy band diagram is reformed as depicted in the same figure. The thickness of the electron accumulation (14) does not exceed the spread of electron wave, which is several tens of Angstroms.

Although Figure 4 shows a case in which the magnitude of Schottky barrier between the metal layer (10) and the n-type AlGaAs layer (1) is larger than the barrier gap which appears between the GaAs layer (2) and the n-type AlGaAs layer (1) due to the difference in electron affinity, the other case in which the situation is reversed is also possible. In any case, however, a certain thickness of an n-type layer (13) remains between the two depletion layers (11) and (12) and effectively keeps the two depletion layers (11) and (12) independent from each other and prevents then from interfering with each other. In other words, the electrons depleted from the depletion layer (11) accumulate along the Schottky surface, and the electrons depleted from the depletion layer (11) independently accumulate in the GaAs layer (2) along the heterojunction to form the electron accumulation (14).

This potential condition does not allow a field effect caused by a positive or negative voltage applied to the metal layer (10) to affect the electron accumulation (14). Moreover, the remaining n-type layer in which the electron mobility is relatively low forms another conductive channel between the source and drain and consequently deteriorates the linearity of the characteristics and the switching speed of the device. Therefore, it is clear that this layer configuration is not suitable to function as an active device.

A condition is available for the layer configuration shown in Figure 4 not to allow an n-layer (13) to remain in the n-type AlGaAs layer (1) or to fill the n-type AlGaAs layer (1) only with the depletion layers (11) and (12), when the thickness of the n-type AlGaAs layer is decreased. An example of this condition is shown in Figure 5. When a negative voltage is applied to the metal layer (10), a depletion layer spreads into the GaAs layer (2). As a result, since the energy band diagram is reformed as shown in Figure 6, the electron concentration in the electron accumulation (14) decreases. This means that the conductivity of a channel constituted with the electron accumulation (14) formed in the GaAs layer (2) along the single heterojunction can be regulated by application of a negative potential applied to the metal layer (10).

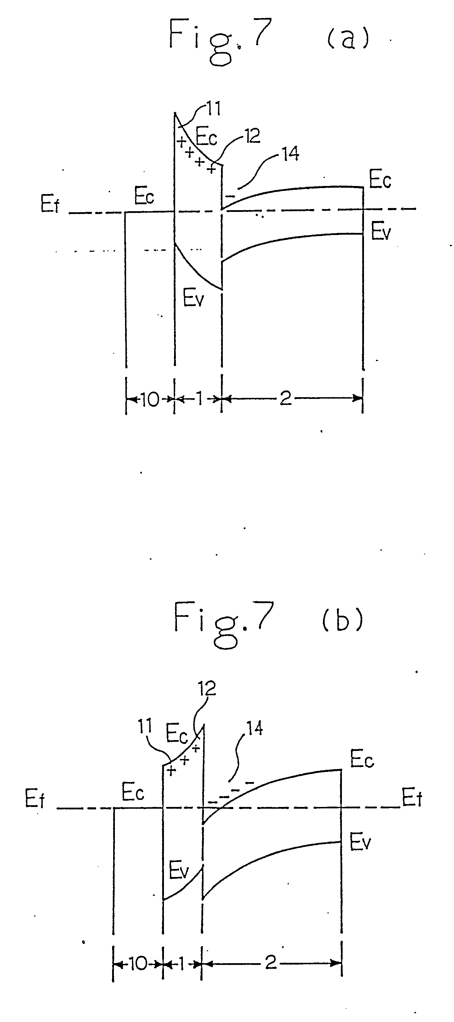

Although Figures 5 and 6 show the case in which the Schottky barrier between the metal layer (10) and the n-type AlGaAs layer (1) is larger than the barrier gap between the GaAs layer (2) and the n-type AlGaAs layer (1) due to the difference in electron affinity, the other case in which the magnitude of barrier gaps is reversed is also available. In this case, a different function results. Namely ,when the thickness of the n-type AlGaAs layer (1) is further decreased, two different shapes as shown in Figures 7(a) and 7(b) are available for the energy band diagram. Figure 7(a) shows a case in which the barrier gap between the metal layer (10) and the n-type AlGaAs (1) is larger than the barrier gap which appears between the GaAs layer (2) and the n-type AlGaAs layer (1) due to the difference in electron affinity. If the thickness of the n-type AlGaAs layer (1) is further decreased, the depletion layer (12) will not appear. In this case, the concentration of the electron accumulation (14) becomes extremely small, and this thickness of the n-type AlGaAs layer (1) constitutes a boundary of the range in which the negative regulation of conductivity is possible. On the other hand, Figure 7(b) shows a case in which the barrier gap between the metal layer (10) and the n-type AlGaAs layer (1) is smaller than the barrier gap which appears between the GaAs layer (2) and the n-type AlGaAs layer (1) due to the difference in electron affinity . If the thickness of the n-type AlGaAs layer (1) is further decreased, the depletion layer (11) does not appear. In this case, although some means is necessary to confine electrons along the interface between the metal layer (10) and the n-type AlGaAs layer (1), this thickness of the n-type AlGaAs layer (1) does not constitute a boundary of the range in which the negative regulation of conductivity is possible. In other words, this thickness of the n-type AlGaAs layer (1) still allows the negative regulation of conductivity.

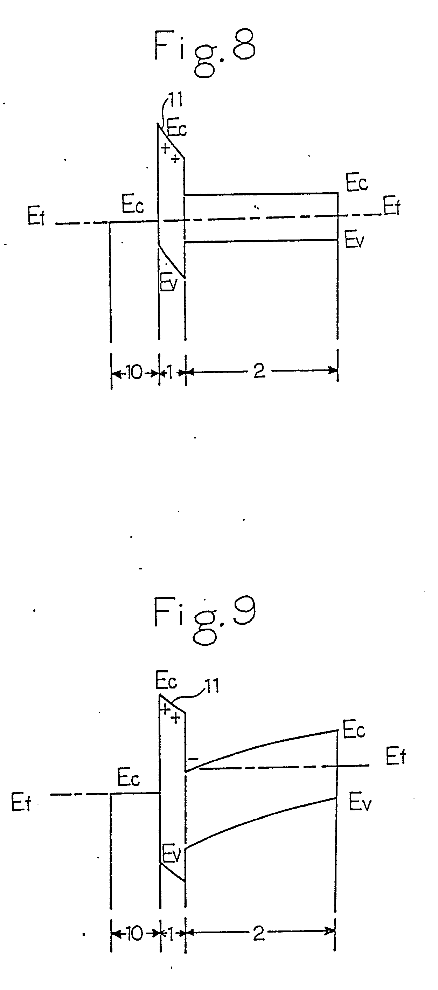

Referring again to Figure 7(a), when the thickness of the n-type AlGaAs layer (1) is further decreased, no electrons are supplied to the GaAs layer (2), and the electron accumulation (14) does not appear, as shown in Figure 8, under the thermal equilibrium condition. Therefore, a positive voltage applied to the metal layer (10) causes an electron accumulation (14) in the GaAs layer (2) due to the function of a capacitor constituted by the metal layer (10), the depletion layer (11) and the GaAs layer (2). As a result, the energy band diagram is reformed as shown in Figure 9. This means that a positive regulation of conductivity is possible for this layer configuration.

It has become clear that active semiconductor devices with high electron mobility can be produced by growing an n-type semiconductor layer having a lower amount of electron affinity on a semiconductor layer having a larger amount of electron affinity, before one or more gates of a rectifying material and a source and a drain are placed on the semiconductor layers.

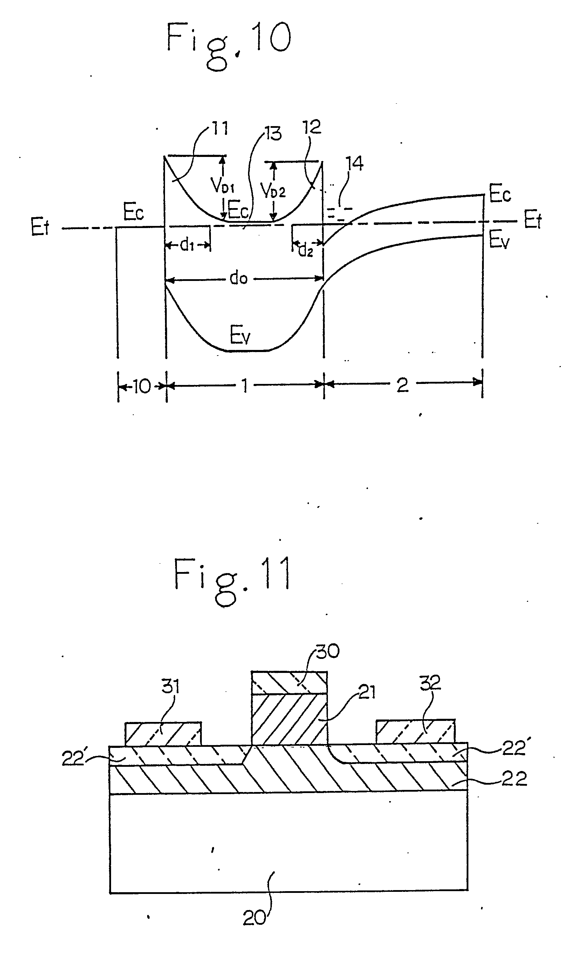

The numerical limitations for the thickness of the n-type AlGaAs layer (1) which were referred to above will be considered below. At first, referring to Figure 10 which is virtually identical to Figure 4, each variable is defined below. $V_{D1}$ is the Schottky barrier between the metal layer (10) and the n-type AlGaAs layer (1). The thickness of the depletion layer (11) is depicted with $d_1$. $V_{D2}$ is the energy barrier between the n-type AlGaAs layer (1) and the GaAs layer (2). The thickness of the depletion layer (12) is depicted with $d_2$. The thickness of the n-type AlGaAs layer (1) is depicted with $d_o$. The total thickness d of the two depletion layers (11) and (12) is

$$d = d_1 + d_2 = (\frac{2\epsilon_S}{q \, N_D})^{\frac{1}{2}} \{(V_{D1} - kT/q)^{\frac{1}{2}} +$$

$$( V_{D2} - kT/q)^{\frac{1}{2}} \} \quad \ldots\ldots\ldots\ldots\ldots\ldots\ldots(1)$$

wherein,

$N_D$ is the impurity concentration of the n-type AlGaAs layer (1),

$\epsilon_S$ is the dielectric constant of the n-type AlGaAS layer (1),

q is the charge of an electron,

k is Boltzmann's constant, and

T is the absolute temperature at which the device works. The higher limit ($d_0$) of the thickness range of the n-type AlGaAs layer (1) which allows the negative regulation of conductivity or which allows the condition shown in Figures 5 and 6 is

$d_0 \doteq d_1 + d_2$     (2)

In other words, the higher limit ($d_0$) must be identical to the cumulative thickness of the two depletion layers (11) and (12). The layer configuration which satisfies this thickness limitation allows regulation of the concentration of the electron accumulation (14) with the negative voltage applied to the gate. This conclusion was proved for the layer configuration described above containing an 800-Angstrom AlGaAs layer with a donor concentration of $6 \times 10^{17}/cm^3$. The surface electron concentration $N_S$ of the electron accumulation (14), determined by utilization of Hall effect, showed a linear change from $8 \times 10^{11}/cm^2$ to $2 \times 10^{11}/cm^2$ for the gate-source voltage variation between 0V (zero volt) and -3.5V.

As described earlier, the thickness ($d_0$) range of the n-type AlGaAs layer (1) workable as an active device is

$0 < d_0 \leq d_1 + d_2$     (3)

Within this thickness range, however, the function varies depending on specific conditions.

In the case where the energy barrier ($V_{D1}$) between the metal layer (10) and the n-type AlGaAs layer (1) is less than the energy barrier ($V_{D2}$) between the n-type AlGaAs layer (1) and the GaAs layer (2) due to the difference in electron affinity, namely in the case of $V_{D1} < V_{D2}$, the electron accumulation (14) is always available in the GaAs layer (2) as shown in Figure 7(b), regardless of the thickness of the n-type AlGaAs layer (1). Therefore, regardless of the thickness of the n-type AlGaAs layer (1), regulation for conductivity is possible for this layer configuration with a negative voltage applied to a gate. As a result, under these conditions, this layer configuration can be utilized as a normally-on mode (depletion mode) FET. Within this thickness range, variation in thickness corresponds to variation in characteristics. Namely, a lower, thickness of the n-type AlGaAs layer (1) causes a lower electron concentration for the electron accumulation (14). In this case, however, a larger magnitude of field effect due to the lower thickness of the n-type AlGaAs layer (1) causes a better sensitivity.

In the case where the energy barrier ($V_{D1}$) between the metal layer (10) and the n-type AlGaAs layer (1) is larger than the energy barrier ($V_{D2}$) between the n-type AlGaAs layer (1) and the GaAs layer (2) due to the difference in electron affinity, namely in the case of $V_{D1} > V_{D2}$, the situation differs depending on whether the thickness ($d_0$) of the n-type AlGaAs layer (1) is

$d_1 < d_0 \leq d_1 + d_2$     (4)

or

$0 < d_0 \leq d_1$     (5)

In the case where the inequality (4) is satisfied, the band diagrams shown in Figures 5, 6 and 7(a) are realised. In the case where inequality (5) is satisfied, the band diagrams shown in Figures 8 and 9 are realised. In the former case, since the electron accumulation (14) is available in the GaAs layer (2), regulation for conductivity is possible with a negative voltage applied to a gate. Therefore, a normally-on mode (depletion mode) FET can be produced with this layer configuration. In the latter case, regulation for conductivity is possible with a positive voltage applied to a gate. Therefore, a normally-off mode (enhancement mode) FET can be produced with this layer configuration. In the case of $d_0 = d_1$, the pinch-off voltage becomes 0V (zero volt). With this thickness range, variation in thickness corresponds to variation in characteristics. Namely , a lower thickness of the n-type AlGaAs layer (1) causes a lower electron concentration for the electron accumulation (14). In this case, however, a larger magnitude of field effect due to the lower thickness of the n-type AlGaAs layer (1) causes a better sensitivity.

One example of a production method will be described below each for the normally-on mode (depletion mode) FET and the normally-off mode (enhancement mode) FET, supposing $Al_{0.3}Ga_{0.7}As$ and GaAs are respectively employed for fabrication of an electron source region and a channel region.

Figure 11 shows a completed normally-on mode (depletion mode) FET as an example of the invention. The first step is to grow a GaAs layer with a thickness of approximately 3,000 Angstroms onto a non-conductive or semi-insulator GaAs substrate (20) employing for example an MBE (Molecular Beam Epitaxy) process. Reference numeral (22) depicts the GaAs layer or the channel region. Although the impurity concentration is free for the channel region unless it is highly doped, undoped or marginally p-type or n-type is preferable. The second step is to grow an AlGaAs layer with a thickness of approximately 800 Angstroms on the channel region (22) employing for example an MBE process. This AlGaAs layer or the electron source region (21) is doped with Si to $6 \times 10^{17}/cm^3$. The third step is to fabricate an aluminium gate (30) employing evaporation and lithography processes, before removing a portion of the electron source region (21) excepting under the gate (30). The fourth step is to introduce some dopant to the surface of the channel region (22) for reduction of resistance. The fifth step is to fabricate source and drain ohmic contacts (31,32) by means of a metallization with gold-germanium eutectic alloy.

The amount of Schottky barrier between aluminium and n-type AlGaAs is 1.5V, and the amount of energy gap between AlGaAs and GaAs due to the difference in electron affinity is 0.4V. Since the dielectric constant of AlGaAs is 11 (eleven), the $d_0$ of the equation (1) is

$$d_0 = d_1 + d_2 = 550\text{\AA} + 280\text{\AA} = 830\text{\AA}$$

Therefore, the n-type AlGaAs layer with the thickness of 800 Angstroms is entirely depleted to cause the electron accumulation in the channel region (22). As a result, this device functions as a normally-on mode (depletion mode) FET. Measurement of the source-drain current vs. the source-drain voltage characteristic at $300^\circ$ K and $77^\circ$ K successfully demonstrated that the transfer conductance $G_m$ is considerably improved for this device.

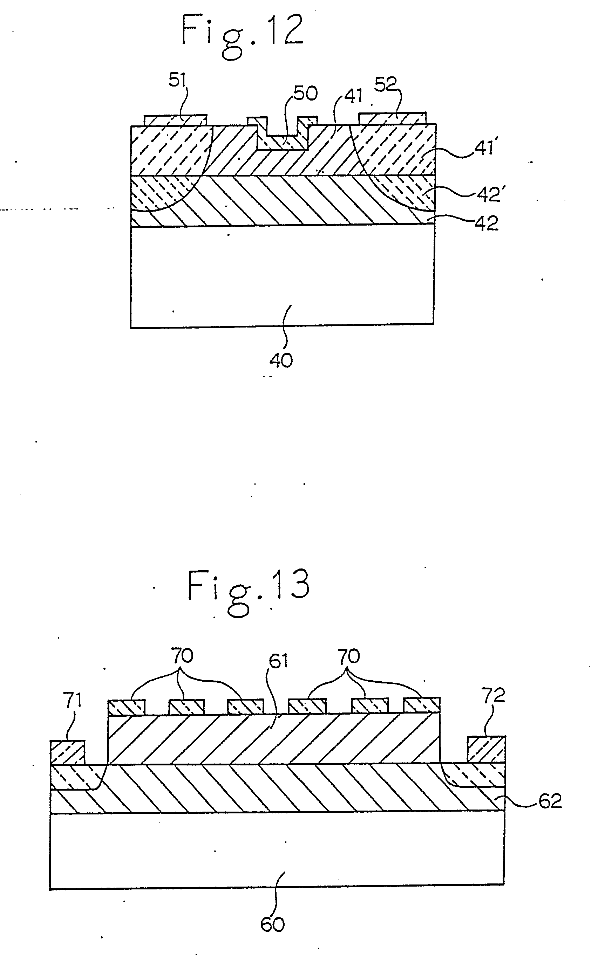

Figure 12 shows a completed normally-off mode (enhancement mode) FET embodying the invention. The production method is quite similar to that which was described above. The major differences are that the thickness of the n-type AlGaAs is 700 Angstroms, the thickness of the n-type AlGaAs is partly decreased to 400 Angstroms under the gate electrode and the doping depth is relatively deep for the source and drain regions. Reference numerals (40), (41), (42), (41') and (42') are respectively a non-conductive substrate, an n-type AlGaAs layer (an electron source region), a GaAs layer (a channel region), a doped region for a source and a doped region for a drain. Reference numerals (50), (51) and (52) are respectively a gate, a source and a drain.

Since the thickness of the electron source region (41) is reduced to 400 Angstroms under the gate (50), the requirement of the equation (5) or $0 < d_0 \leq d_1$ is satisfied, and no electron accumulation is allowed in the channel region insofar as the portion under the gate is concerned. On the other hand, the source (51) and the drain (52) keep contact with the channel constituted by the electron accumulation. Therefore, this device functions as a normally-off mode (enhancement mode) FET. Measurement of the source-drain current vs. source-drain voltage characteristic at $300^\circ$ K and $77^\circ$ K successfully demonstrated that the transfer conductance $G_m$ is considerably improved for this device.

It has become clear that the above embodiments of the invention provide active semiconductor devices with high electron mobility particularly at cryogenic temperature.

Further, it has been demonstrated that the electron mobility in the electron accumulation formed along the heterojunction is improved not only at cyrogenic temperature but also at ordinary ambient temperature, albeit the magnitude of the improvement is not so significant as at cryogenic temperature.

The invention can be embodied in charge coupled devices as shown in Fig. 13. Referring to the Figure, reference numerals (60), (61), (62), (70), (71) and (72) are respectively a substrate, an electron source region, a channel region, gates, an input terminal and an output terminal. In the art, the latter two terminals may both be called output terminals.

As is clear from the above description, this invention may be performed in a wide variety of ways. Firstly, pairs of channel regions and electron source regions are selected from the couples of materials each of which has a rather big difference in electron affinity and also in energy gap from each other and has similar crystal lattice index and coefficient of expansion et al. to each other. Some of the exemplary couples are tabulated below:

| Item | Material | Band gap | Crystal lattice index | Electron affinity |
|------|----------|----------|-----------------------|-------------------|
|      |          | eV       | Angstrom              | eV                |
| 1    | AlGaAs   | 2.0      | 5.657                 | 3.77              |
|      | GaAs     | 1.43     | 5.654                 | 4.07              |
| 2    | AlGaAs   | 2.0      | 5.657                 | 3.77              |
|      | Ge       | 0.66     | 5.658                 | 4.13              |
| 3    | GaAs     | 1.43     | 5.654                 | 4.07              |
|      | Ge       | 0.66     | 5.658                 | 4.13              |
| 4    | CdTe     | 1.44     | 6.477                 | 4.28              |
|      | InSb     | 0.17     | 6.479                 | 4.59              |
| 5    | GaSb     | 0.68     | 6.095                 | 4.06              |
|      | InAs     | 0.36     | 0.058                 | 4.9               |

Secondly, any type of non-conductive substrate is acceptable. Thus, either a semiconductor or an insulator is acceptable. An important requirement is to form a single channel between input and output terminals along a single heterojunction formed between a channel region of a material having a lower electron affinity and an electron source region of a material having a larger electron affinity.

**Claims**

1. An active semicondutor device, comprising
a source layer (1, 21, 41, 61) of a semiconductor doped with donor impurity,
a channel layer (2, 22, 42, 62) of a semiconductor having a larger electron affinity than the semiconductor of the source layer and forming a heterojunction with the source layer, wherein a channel is formed in the channel layer along the heterojunction,
at least one control terminal (10, 30, 50; 70), having a Schottky gate configuration, formed on the source layer over a portion of said heterojunction, and
first (31, 32; 51,52; 71,72) and second (32, 31; 52,51; 72,71) output terminals;
said source layer having a sufficiently small thickness, at least under the said one control terminal, so as to be entirely depleted of majority carriers under the said one control terminal,
wherein said first and second output terminals are electrically connected, at least under said one control terminal, by an accumulation of electrons with high mobility in said channel in said channel layer depending on a control voltage applied to said control terminal.

2. A semiconductor device according to claim 1, where said source layer has a thickness, under the said one control terminal, equal to or less than

$$( \frac{2\varepsilon_S}{qN_D} )^{\frac{1}{2}} \cdot \{ (V_{D1} - \frac{kT}{q})^{\frac{1}{2}} + ( V_{D2} - \frac{kT}{q})^{\frac{1}{2}} \}$$

wherein,
$\varepsilon_S$ is the dielectric constant of said source layer,
$N_D$ is the negative impurity concentration doped in said source layer,
$V_{D1}$ is the energy barrier between said source layer and said at least one control terminal,
$V_{D2}$ is the energy barrier between said source layer and said channel layer,
k is Boltzmann's constant,
q is the charge of an electron, and
T is the absolute temperature at which said semiconductor device operates.

3. A semiconductor device according to claim 2, wherein the source layer has a thickness, under said one control terminal, equal to or less than

$$\left(\frac{2\varepsilon_S}{qN_D}\right)^{\frac{1}{2}} \left(V_{D1} - \frac{kT}{q}\right)^{\frac{1}{2}} .$$

4. A semiconductor device according to claim 2, wherein the source layer has a thickness, under said one control terminal, greater than

$$\left(\frac{2\varepsilon_S}{qN_D}\right)^{\frac{1}{2}} \left(V_{D1} - \frac{kT}{q}\right)^{\frac{1}{2}} .$$

5. A semiconductor device as claimed in claim 2, 3 or 4, wherein $V_{D1} > V_{D2}$.

6. A semiconductor device as claimed in claim 2, 3 or 4, wherein $V_{D1} < V_{D2}$.

7. A semiconductor device according to any preceding claim, wherein the channel layer is grown on a substrate of a substantially non-conductive material.

# Fig.1

# Fig.2

# Fig. 3

Electron Concentration

|←4→|←5→|←4→|←5→|←4→|← 3

Depth from the surface

# Fig. 4

|←10→|← 1 →|← 2 →|

Fig. 5

Fig. 6

Fig.7 (a)

Fig.7 (b)

Fig.8

Fig.9

# Fig. 10

# Fig. 11

# Fig.12

# Fig.13

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| D,P<br>A | EP-A-0 017 531 ("THOMSON-CSF"-SCPI)<br>* Page 8, line 17 - page 9, line 32; page 12, line 1 - page 14, line 19; page 15, lines 12-17; figures 3,4,6-8,10 * | 1,2,6 | H 01 L 29/80<br>H 01 L 29/205<br>H 01 L 29/267 |
| A | PROCEEDINGS OF THE IEEE, Proceedings letters, vol. 54, no. 12, December 1966, page 1960, IEEE, New York, US; G. ZEIDENBERGS et al.: "A proposed heterojunction field-effect transistor"<br>* Whole article * | 1,6 | |
| A | SOLID STATE COMMUNICATIONS, vol. 29, no. 10, March 1979, pages 705-709, Pergamon Press Ltd, GB; E.L. STÖRMER et al.: "Two-dimensional electron gas at a semiconductor-semiconductor interface"<br>* Page 705, left-hand column, lines 21-32 * | 1 | |
| P,A | JAPANESE JOURNAL OF APPLIED PHYSICS, vol. 19, no. 5, May 1980, pages L225-L227; T. MIMURA et al.: "A new field-effect transistor with selectively doped GaAs/n-AlxGa1-xAs heterojunctions"<br>* Page L225, line 26 - page L226, line 12; figures 1,3a * | 1,4,5 | TECHNICAL FIELDS SEARCHED (Int. Cl.4)<br><br>H 01 L |

The present search report has been drawn up for all claims

| Place of search | Date of completion of the search | Examiner |
|---|---|---|
| THE HAGUE | 08-02-1989 | MORVAN D.L.D. |